# EUROPEAN PATENT APPLICATION

(11) **EP 2 011 844 A1**
(43) Date of publication of application: **07.01.2009**
(21) Application number: 07737104.5
(22) Date of filing: 24.04.2007
(51) Int. Cl.: C09J 7/02, C09J 9/02, C09J 11/04, C09J 11/06, C09J 133/00, C09J 163/00, C09J 163/02, C09J 163/04, C09J 201/00, H01L 25/065, H01L 25/07, H01L 25/18

(54) **ADHESIVE TAPE, SEMICONDUCTOR PACKAGE, AND ELECTRONIC DEVICE**

(30) Priority: 27.04.2006 JP 2006123468
(71) Applicant: Sumitomo Bakelite Co., Ltd., Shinagawa-ku Tokyo 140-0002 (JP)
(72) Inventor: KATSURAYAMA, Satoru, Shinagawa-ku, Tokyo 140-0002 (JP); YAMASHIRO, Tomoe, Shinagawa-ku, Tokyo 140-0002 (JP); MIYAMOTO, Tetsuya, Shinagawa-ku, Tokyo 140-0002 (JP)
(74) Representative: Cramphorn, Conrad
(86) International application number: PCT/JP2007/000447
(87) International publication number: WO 2007/125650

(57) **Abstract**

An adhesive tape electrically connecting conductive members contains a resin, a solder powder and a curing agent having flux activity, wherein the solder powder and the curing agent having flux activity are contained in the resin.

## Description

### TECHNICAL FIELD

The present invention relates to an adhesive tape as well as a semiconductor package and electronics therewith.

### BACKGROUND ART

A known adhesive tape for connection between conductive members such as electrodes is an adhesive tape containing solder particles (Patent Document 1). Patent Document 1 has described an anisotropic conductive film (ACF) containing solder particles as conductive particles.

Patent Document 2 has described a method for connecting terminals using a conductive adhesive containing conductive particles and a resin component. According to the method described in the document, a conductive adhesive is applied between terminals, heated at a temperature which is higher than the melting point of the conductive particles but does not allow the resin to be cured, and then cured a resin. The document has also described that as a resin, an epoxy resin capable of activating conductive particles and an electrode surface may be used. It has also described that the conductive adhesive may contain a flux.

Patent Document 3 has described that a polyimide circuit board having a metallized pattern is coated by a mixture of solder balls, a flux agent such as malic acid and an epoxy resin. The document has also described that on the metal pattern in the printed circuit board is sprayed a solution of malic acid, over which is applied an epoxy film filled with solder balls, and a solution of malic acid is sprayed on the adhesive and then an integrated circuit is placed in a face-down manner.
[Patent Document 1] Japanese Laid-open patent publication NO. 1986-276873
[Patent Document 2] Japanese Laid-open patent publication NO. 2004-260131
[Patent Document 3] Japanese Laid-open patent publication NO. 4-262890

### DISCLOSURE OF THE INVENTION

### PROBLEM TO BE SOLVED BY THE INVENTION

However, when using an adhesive tape containing solder particles as described in Patent Document 1, a low resistance is not consistently achieved in a junction portion, and there is thus room for improvement in terms of connection reliability.

Furthermore, not exclusively to those containing solder particles, it has been difficult to control curing behavior of a resin in an ACF. That is, when a resin slowly cures, conductive particles between electrodes are so diffused that connection cannot be ensured. On the other hand, when a resin rapidly cures, a resin present between conductive particles and a conductive member cures so rapidly that an insulating layer is formed between them.

Generally, in an ACF, a conductive particle is a plastic core plated with Ni/Au, and contact of a conductive particle with a conductive member leads to conduction between the upper and the lower materials. Thus, thermal expansion and contraction of a surrounding resin results in fluctuation in a contact area of a conductive particle to a conductive member, leading to an unstable connection resistance.

In the conductive adhesives described in Patent Documents 2 and 3, an adhesive is applied to an electrode or a substrate surface. Thus, an adhesion process is troublesome. Furthermore, there is room for improvement in terms of connection reliability.

In view of the above situation, the present invention provides an adhesive tape and a semiconductor package exhibiting excellent bonding reliability.

### MEANS FOR SOLVING PROBLEM

According to the present invention, there is provided an adhesive tape electrically connecting conductive members, comprising
a resin,
a solder powder and
a curing agent having flux activity,
wherein the solder powder and the curing agent having flux activity are contained in the resin.

In the adhesive tape of the present invention, the solder powder and the curing agent having flux activity are contained in the resin. Of these, the solder powder contained in the resin moves, by heating, to a conductive member surface in a self-aligning manner.

Furthermore, in the present invention, the curing agent having flux activity contained in the resin efficiently moves to an interface between the conductive member and the solder, ensuring electric connection between the conductive member and the solder.

A curing agent having flux activity has been used as a mixture with a solder powder. In Patent Document 2 described in "BACKGROUND ART", an epoxy resin itself has surface activity.

In contrast, in the present invention, a curing agent having flux activity is contained in a resin in a tape type adhesive, so that compared with the structure described above, a curing agent having flux activity can more easily move to an interface between a conductive member and a solder during an adhesion process. Thus, according to the present invention, electric connection can be reliably and stably formed between a solder powder and a conductive member.

In a conventional ACF, as described in "PROBLEMS TO BE SOLVED BY THE INVENTION", it is difficult to control curing behavior of a resin. Incontrast, in the present invention, a curing agent having f lux activity is contained in a resin, so that curing properties of a resin is more controllable. Furthermore, in an adhesive tape of the present invention, solder particles are concentrated in an electrode due to self-alignment effect, to form stable metal bonding. This is because in the present invention, the solder powder exhibits good wettability to an exposed metal area and are concentrated in the metal area.

In addition, the curing agent having flux activity is reactive to a resin, resulting in less outgassing and thus prevention of contamination of electronic components. Furthermore, a flux activity agent does not act as an ionic impurity, so that corrosion of a conductive member can be prevented.

Since the adhesive has a form of tape in the present invention, it is not necessary to apply it on a surface between elements to be attached. It leads to a simpler adhesion process.

Any combination of the foregoing elements or modified expression of the invention among a process, an apparatus and the like are also effective as an aspect of the present invention.

For example, according to the present invention, there is provided electronics where electronic or electric components are connected via the above adhesive tape.
According to the present invention, there is also provided a semiconductor package comprising
a chip-mounting substrate, and
a first and a second semiconductor chips deposited on one surface of the chip-mounting substrate,
wherein the first and the second semiconductor chips are bonded via the adhesive tape as claimed in Claim 1.
According to the present invention, there is also provided a semiconductor package comprising
a first substrate mounting a semiconductor chip and
a second substrate mounting the first substrate,
wherein the first and the second substrates are bonded via the adhesive tape as claimed in Claim 1.

### ADVANTAGE OF THE INVENTION

As described above, in an adhesive tape of the present invention, a solder powder and a curing agent having flux activity are contained in a resin, so that connection reliability between conductive members can be improved.

### BRIEF DESCRIPTION OF THE DRAWINGS

These and other objectives, features and advantages will become more apparent by reference to the following suitable embodiments and the accompanying drawing.

[FIG. 1] FIG. 1 is a cross-sectional view illustrating an adhesion method using an adhesive tape in an embodiment.
[FIG. 2] FIG. 2 is a cross-sectional view illustrating an adhesion method using an adhesive tape in an embodiment.
[FIG. 3] FIG. 3 is a cross-sectional view illustrating an adhesionmethod using an adhesive tape in an embodiment.
[FIG. 4] FIG. 4 is a cross-sectional view illustrating a configuration of a semiconductor package in an embodiment.
[FIG. 5] FIG. 5 is a cross-sectional view illustrating a configuration of a semiconductor package in an embodiment.
[FIG. 6] FIG. 6 is a cross-sectional view illustrating a configuration of a semiconductor package in an embodiment.
[FIG. 7] FIG. 7 is a cross-sectional view illustrating the structure of a stack in an example.
[FIG. 8] FIG. 8 is a cross-sectional view illustrating the structure of a stack in an example.

### REFERENCE NUMERALS

101: adhesive tape, 103: solder powder, 105: third substrate, 107: second substrate, 109: first substrate, 111: solder region, 113: first electrode, 115: second electrode, 117: via, 119: third electrode, 121: second electrode, 131: second base material, 132: resin, 133: first base material, 135: second electrode, 137: first electrode, 139: second solder resist layer, 141: first solder resist layer, 143: void, 151: first semiconductor chip, 153: second semiconductor chip, 155: mounting substrate, 157: substrate, 159: wire, 161: bump electrode, 163: encapsulating resin, 165: bump electrode, 167: resin, 169: wire, and 171: wire

### BEST MODE FOR CARRYING OUT THE INVENTION

There will be described embodiments of the present invention with reference to the drawing. In all of the figures, a common element is denoted by the same symbol and will not be repeated.

An adhesive tape of the present invention forms electric connection between conductive members and contains a resin, a solder powder and a curing agent having flux activity. Among these, the solder powder and the curing agent having flux activity are contained in a resin. Each component will be specifically described.

The resin may be, but not limited to, a thermoplastic resin, a thermosetting resin or a mixture of a thermoplastic resin and a thermosetting resin. Among these, a mixture of a thermoplastic resin and a thermosetting resin is suitable in the light of depositability and melt viscosity of the resin.

Examples of the thermoplastic resin include, but not limited to, phenoxy resins, polyester resins, polyurethane resins, polyimide resins, siloxane-modified polyimide resins, polybutadiene, polypropylene, styrene-butadiene-styrene copolymers, styrene-ethylene-butyrene-styrene copolymers, polyacetal resins, polyvinylbutyral resins, polyvinylacetal resins, butyl rubbers, chloroprene rubbers, polyamide resins, acrylonitrile-butadiene copolymers, acrylonitrile-butadiene-acrylic acid copolymers, acrylonitrile-butadiene-styrene copolymers, polyvinyl acetate, Nylon, acrylic rubbers and so forth, which may be used alone or in combination of two or more.

The thermoplastic resin may have a nitrile group, an epoxy group, a hydroxy group or a carboxyl group for the purpose of improving adhesiveness and compatibility with another resin, and an example of such a resin is an acrylic rubber.

Examples of the thermosetting resin include, but not limited to, epoxy resins, oxetane resins, phenol resins, (meth) acrylate resins, unsaturated polyester resins, diaryl phthalate resins, maleimide resins and so forth. Among these, preferred is an epoxy resin which exhibits excellent curability and an improved shelf life as well as excellent heat resistance, moisture resistance and chemical resistance in its cured product.

The epoxy resin may be a solid or liquid epoxy resin at an ambient temperature. Alternatively, it may contain a solid and a liquid epoxy resins at an ambient temperature, whichmay further improve freedom of designing melting behavior of the resin.

Examples of the epoxy resin which is solid at an ambient temperature include, but not limited to, bisphenol A type epoxy resins, bisphenol S type epoxy resins, phenol novolac type epoxy resins, cresol novolac type epoxy resins, glycidylamine type epoxy resins, glycidyl ester type epoxy resins, trifunctional epoxy resins and tetrafunctional epoxy resins. More specifically, the resin may contain a solid trifunctional epoxy resin and a cresol novolac type epoxy resin. Examples of the solid trifunctional epoxy resin and the cresol novolac type epoxy resin include 2-[4-(2,3-epoxypropoxy)phenyl]-2-[4-[1,1-bis[4-(2,3-epoxypropoxy)p henyl]ethyl]phenyl]propane and 1,3-bis[4-[1-[4-(2,3-epoxypropoxy)phenyl]-1-[4-[1-[4-(2,3-epoxypro poxy)phenyl]-1-methyl]ethyl]phenyl]phenoxy]-2-propanol which are used in Examples described later.

The liquid epoxy resin at an ambient temperature may be a bisphenol A type epoxy resin or a bisphenol F type epoxy resin. Alternatively, it may be a combination of these.

Alternatively, the solid epoxy resin at an ambient temperature may contain a solid trifunctional epoxy resin and a cresol novolac type epoxy resin, while the liquid epoxy resin at an ambient temperature may be a bisphenol A type epoxy resin or bisphenol F type epoxy resin.

A specific example of a mixture of a thermoplastic resin and a thermosetting resin is a system where the resin contains an epoxy resin and an acrylic rubber. A system where the resin contains an acrylic rubber may improve deposition stability during preparing a film type adhesive tape. Such a system may lead to a lower elastic modulus of an adhesive tape, reduction in a residual stress between a bondedmaterial and the adhesive tape, resulting in improved adhesiveness to the bonded material.

A content of a resin in an adhesive tape of the present invention, for example, an acrylic rubber, is 10 to 50 % by weight both inclusive to the total of the components in the adhesive tape except a solder powder. When a content of the acrylic rubber is 10 % by weight or more, deterioration in depositability and increase in an elastic modulus of an adhesive tape after curing can be prevented, resulting in further improvement in adhesiveness to a bonded material. When a content of the acrylic rubber is 50 % by weight or less, increase in a melt viscosity in the resin can be prevented, resulting in further reliable transfer of the solder powder to the surface of the conductive member.

A content of the epoxy resin is, for example, 20 to 80 % by weight both inclusive to the total of the adhesive tape except the solder powder. When a content of the epoxy resin is 20 % by weight or more, a sufficient elastic modulus can be further ensured after adhesion, resulting in improvement in connection reliability. When a content of the epoxy resin is 80 % by weight or less, a melt viscosity can be further improved to prevent deterioration in connection reliability due to runoff of the solder powder from the bonded material.

Another example of a mixture of a thermoplastic resin and a thermosetting resin is a system where the resin contains an epoxy resin and a phenoxy resin. It allows for more suitably satisfying both heat resistance and moisture resistance after curing an adhesive tape.
Specific examples of the epoxy resin include those materials described above.
Specific examples of the phenoxy resin include bisphenol A type, bisphenol F type, bisphenol S type and fluorene-containing resins.

In the light of improvement of depositability of an adhesive tape, a content of the phenoxy resin in the resin is, for example, 10 % by weight or more, preferably 15 % by weight or more, to the total of the components of the adhesive tape except a solder powder. Thus, adhesiveness derived from hydroxy groups contained in the phenoxy resin can be further reliably ensured. Furthermore, a content of the phenoxy resin is, for example, 50 % by weight or less, preferably 40 % by weight or less to the total of the components of the adhesive tape except a solder powder, in the light of further ensuring transfer of the solder powder to the surface of the conductive member while preventing excessive increase in a melt viscosity of the resin.

In the light of reliable transfer of the solder powder in the resin, a curing temperature of the resin is preferably higher than a melting temperature of the solder powder described later. More specifically, a curing temperature of the resin is preferably higher by 10 °C or more, preferably 20 °C or more than a melting point of the solder. Furthermore, it is preferable that a melt viscosity of the resin at an adhesion temperature is low.

A curing temperature of a resin is an exothermic peak temperature as determined for an adhesive tape using, for example, an DSC (Differential Scanning Calorimeter) at a temperature-increase rate of 10 °C/min.

In an adhesive tape of the present invention, a solder contained in a solder powder may be, for example, a lead-free solder. The lead-free solder is preferably an alloy containing at least two selected from the group consisting of, but not limited to, Sn, Ag, Bi, In, Zn and Cu. Among these, it is preferably an Sn-containing alloy such as an Sn-Bi alloy, an Sn-Ag-Cu alloy and an Sn-In alloy in the light of a melting temperature and mechanical properties of the alloy.

In the light of fully ensuring flowability of a resin during adhesion of an adhesive tape, a melting temperature (melting point) of a solder powder is, for example, 100 °C or higher, preferably 130 °C or higher. A melting temperature of the solder powder is, for example, 250 °C or lower, preferably 230 °C or lower in the light of preventing deterioration in an element mounted in a bonded material such as a substrate and a chip during adhesion.

Herein, a melting temperature of a solder powder is an endothermic peak temperature as determined for a solder powder alone using, for example, an DSC at a temperature-increase rate of 10 °C/min.

In the light of more reliable transfer of the solder powder to the surface of the conductive member, a melting temperature of the solder powder is preferably lower than a curing temperature of the resin.

A particle size of a solder powder may be determined, depending on a surface area of a conductive member and a distance between conductive members. In the light of ensuring transfer of the solder powder to the conductive member surface, an average particle size of the solder powder is, for example, 5 µm or more, preferably 10 µm or more. Furthermore, an average particle size of the solder powder is for example, 100 µm or less, preferably 50 µm or less in the light of selectively forming a solder region in the conductive member surface and ensuring insulation of the adhesive tape in regions other than a region to be made conductive such as an electrode-forming region. Herein, an average particle size of a solder powder is determined by, for example, laser diffraction scattering.

A content of a solder powder in an adhesive tape of the present invention is 20 parts by weight or more, preferably 40 parts by weight or more to the total 100 parts by weight of components except the solder powder in the light of improving connection reliability. In the light of improving depositability of the adhesive tape, the content is 250 parts by weight or less, preferably 230 parts by weight or less to the total 100 parts by weight of components except the solder powder in the adhesive tape.

A curing agent having flux activity used in the present invention is a compound having sufficient reductive capability for an oxidized film on the solder powder surface to electrically connect with a conductive member and having a functional group via which it can be attached to a resin. For example, when the resin contains an epoxy resin, the curing agent having flux activity may have a carboxyl group and a group reactive to an epoxy group. Examples of the group reactive to an epoxy group include a carboxyl group, a hydroxy group and an amino group.

A curing agent having flux activity can be appropriately selected, depending on the type of a solder powder in the light of removal of an oxide film in the surface of the solder powder during adhesion.

A curing agent having flux activity is, for example, a carboxyl group-containing compound. Examples of a carboxyl group-containing compound include carboxylic acids such as alkylcarboxylic acids having a linear or branched chain and aromatic carboxylic acids.

Specific examples of an alkyl carboxylic acid include compounds represented by the following formula (1).

HOOC-(CH₂)ₙ-COOH (1)

In the above formula (1), n is an integer of 0 to 20 both inclusive.
In the light of balance among flux activity, outgassing during adhesion and an elastic modulus and a glass-transition temperature of an adhesive tape after curing, n in the formula (1) is preferably 4 to 10 both inclusive. When n is 4 or more, increase in an elastic modulus after curing the adhesive tape due to a too short crosslink distance in the epoxy resin can be prevented, resulting in improvement in adhesiveness to a bonded material. When n is 10 or less, reduction in an elastic modulus due to a too long crosslink distance in the epoxy resin can be prevented, resulting in further improvement in connection reliability.

Examples of the compound represented by the formula (1) include adipic acid with n=4 (HOOC-(CH₂)₄-COOH), sebacic acid with n=8 (HOOC- (CH₂)₈-COOH) and HOOC- (CH₂)₁₀-COOH with n=10.

Further specific examples of the aromatic carboxylic acid include compounds at least two phenolic hydroxy groups and at least one carboxyl group directly attached to an aromatic moiety in one molecule. Examples of such a compound include benzoic acid derivatives such as 2,3-dihydroxybenzoic acid, 2,4-dihydroxybenzoic acid, gentisic acid (2,5-dihydroxybenzoic acid), 2,6-dihydroxybenzoic acid, 3,4-dihydroxybenzoic acid, gallic acid (3,4,5-trihydroxybenzoic acid) and phenolphthalin (2-[bis(p-hydroxyphenyl)methyl]benzoic acid);
naphthoic acid derivatives such as 1,4-dihydroxy-2-naphthoic acid, 3,5-dihydroxy-2-naphthoic acid and 3,7-dihydroxy-2-naphthoic acid; and
diphenolic acid.

Further specific examples of a curing agent having flux activity include sebacic acid or gentisic acid described above, one or both of which may be contained.

In an adhesive tape of the present invention, a curing agent having flux activity may be outside of a solder powder; for example, a solder powder and a curing agent having flux activity may be independently dispersed in a resin or a curing agent may adhere to a solder powder surface dispersed in a resin. Since the curing agent having flux activity is outside of the solder powder, the curing agent having flux activity efficiently moves to the interface between the solder and a conductive member in a bonded material during adhesion, so that the conductive member can be directly in contact with a solder. Thus, connection reliability can be improved. Furthermore, since the curing agent having flux activity is contained in the resin, it can be efficiently bonded to the resin to increase in an elastic modulus or a Tg (glass-transition temperature).

In an adhesive tape of the present invention, a content of a curing agent having flux activity is for example 0.1 % by weight or more, preferably 1 % by weight or more to the total of components of the adhesive tape except a solder powder in the light of improving flux activity. Furthermore, in the light of reducing a melt viscosity of the resin during adhesion, a content of the curing agent having flux activity is for example 30 % by weight or less, preferably 10 % by weight or less to the total of components in the adhesive tape except a solder powder.

More specifically, when the adhesive tape of the present invention contains an epoxy resin, a content of the curing agent having flux activity is for example 50 % by weight or less, preferably 30 % by weight or less to the epoxy resin in the adhesive tape. Thus, an excessive curing agent can be avoided, resulting in improvement in curability.

In an adhesive tape of the present invention, a resin may further contain, in addition to a curing agent having flux activity, another curing agent or a resin capable of acting as a curing agent.

Examples of a curing agent include, but not limited to, phenols, amines and thiols, and in the light of reactivity with an epoxy resin and physical properties after curing, phenols are suitably used.

Such phenols are preferably, but not limited to, bi- or more functional in the light of physical properties after curing of an adhesive tape. Examples include bisphenol A, tetramethylbisphenol A, diallylbisphenol A, biphenol, bisphenol F, diallylbisphenol F, trisphenol, tetrakisphenol, phenol novolacs and cresol novolacs, and in the light of a melt viscosity, reactivity with an epoxy resin and physical properties after curing, phenol novolacs and cresol novolacs can be suitably used.

A content of a curing agent other than the curing agent having flux activity is for example 5 % by weight or more, preferably 10 % by weight or more to the total 100 % by weight of components of an adhesive tape except a solder powder in the light of reliably curing the resin. Furthermore, in the light of improving flowability of the resin during adhesion, a content of such a curing agent is for example 40 % by weight or less, preferably 30 % by weight or less to the total 100 % by weight of components of an adhesive tape except a solder powder.

The adhesive tape of the present invention may further contain a curing catalyst. By adding a curing catalyst, a resin can be further reliably cured during preparing the adhesive tape.

A curing catalyst may be appropriately selected, depending on the type of a resin used; for example, an imidazole compound having a melting point of 150 °C or higher may be used. An imidazole compound having a too low melting point may lead to unstable connection due to curing of a resin in an adhesive tape before transfer of a solder powder to an electrode surface or reduction of a shelf life of the adhesive tape. Thus, a melting point of the imidazole compound is preferably 150 °C or higher, more preferably 160 °C or higher. Examples of an imidazole compound having a melting point of 150 °C or higher include 2-phenylhydroxyimidazole, 2-phenyl-4-methylhydroxyimidazole, 2-phenyl-4,5-dihydroxyimidazole and 2-phenyl-4-methylimidazole. Without any particular restriction to an upper limit, a melting point of an imidazole compound may be appropriately selected, depending on, for example, an adhesion temperature of an adhesive tape, and for example, it may be 250 °C or lower.

A content of a curing catalyst is for example 0.001 % by weight ormore, preferable 0.01 % by weight or more to the total 100 % of components of an adhesive tape except a solder powder in the light of making the catalyst more effectively act as a curing catalyst for an epoxy resin to improve curability of the adhesive tape. Furthermore, a content of the curing catalyst is for example 5 % by weight or less. Thus, a shelf life of the adhesive tape can be further improved.

An adhesive tape of the present invention may further contain a silane coupling agent. Adding a silane coupling agent may lead to further improvement in adhesiveness of the adhesive tape to a bonded material. Specific examples of a silane coupling agent include an epoxy silane coupling agent and an aromatic-containing aminosilane coupling agent, at least one of which may be conatined. Alternatively, for example, both of these maybe contained. Acontent of the silane coupling agent is for example about 0.01 to 5 % by weight to the total 100 % of components of the adhesive tape except a solder powder.

Furthermore, an adhesive tape of the present invention may contain agents, in addition to those described above. For example, a variety of additives may be appropriately added for improving various properties such as compatibility, stability and processability of a resin.

There will be described a process for preparing an adhesive tape of the present invention. An adhesive tape can be prepared by blending a resin, a solder powder, a curing agent having flux activity and, if necessary, other additives where a solder powder and a curing agent having flux activity are dispersed in the resin, then applying the dispersion thus prepared onto a release base material such as a polyester sheet and then drying it at a predetermined temperature.

In the film type adhesive tape thus prepared, the solder powder and the curing agent having flux activity are contained in the resin. When the resin is placed between the members to be attached and then heated, a solder powder in the resin moves to the surface of a conductive member in a bonded material in a self-aligning manner to form metal bonding.

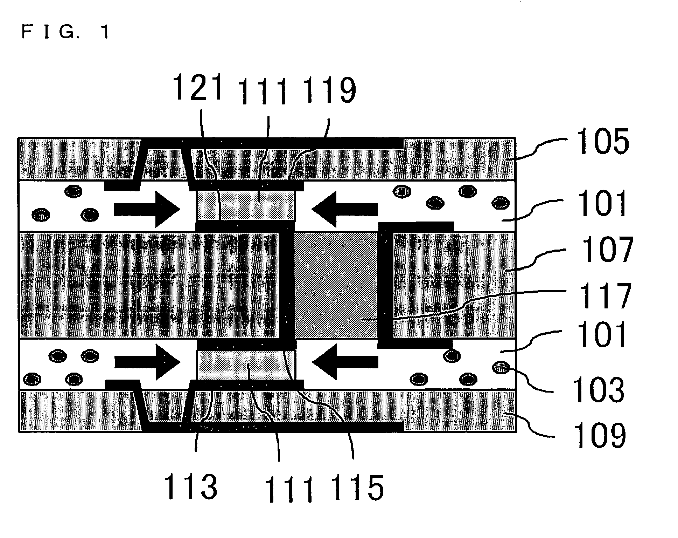

There will be further specifically described an adhesion process using an adhesive tape of the present invention with reference to FIG. 1.
On a first substrate 109, an adhesive tape 101, a second substrate 107, an adhesive tape 101 and a third substrate 105 are sequentially stacked from the bottom. Here, a first electrode 113 in the surface of the first substrate 109 faces to a second electrode 115 in the surface of the second substrate 107. Furthermore, a second electrode 121 in the surface of the second substrate 107 faces to a third electrode 119 in the surface of the third substrate 105.
In the second substrate 107, a predetermined material may be buried within a via 117 or the via 117 may be a throughhole.

Next, the stack is heated at a predetermined temperature for adhesion. An adhesion temperature may be determined, depending on a material of a solder powder 103 in the adhesive tape 101 and a resin material.

An adhesion temperature is a temperature which is higher than a melting temperature of the solder powder 103 and at which the resin is melted. Seen in that light, an adhesion temperature is for example higher than 100 °C, preferably 120 °C or higher. At an adhesion temperature, it is preferable that a resin has a low melt viscosity, and from this point of view, an adhesion temperature is for example 250 °C or lower, preferably 200 °C or less. In the light of extending a region where the resin has a low melt viscosity, a lower temperature is preferable.

In the light of forcing the solder powder 103 to more efficiently move to the electrode surface, a predetermined pressure may be applied during adhesion. An applied pressure is for example 0 MPa or more, preferably 1 MPa or more in the light of more reliably forming a solder region 111. Even when an artificially applied pressure is 0 MPa, a predetermined pressure may be applied to the adhesive tape by a self-weight of a member placed on the adhesive tape. In the light of further improving connection reliability, the pressure is for example 20 MPa or less, preferably 10 MPa or less.

Heating induces melting of the resin in the adhesive tape 101. Furthermore, the solder powder 103 in the adhesive tape 101 is melted. The melted solder powder 103 moves from the inside of the resin (not shown) to an electrode formed in the surface of each substrate in a self-aligning manner. The solder powder 103 are self-aligned in a region through which electrodes face each other, so that the solder region 111 is formed in each of the regions between the first electrode 113 and the second electrode 115 and between the second electrode 121 and the third electrode 119.

A curing agent having flux activity contained in the resin (not shown) efficiently moves to the interface between the solder powder 103 and the electrode while removing an oxide film on the solder powder 103, so that the solder region 111 and each electrode is directly metal-bonded to form electric connection. Then, the stack is cooled to cure the resin in the adhesive tape, and thus the state where the electrodes are bonded via the solder region 111 is maintained.

Thus, using a tape type adhesive tape 101, the substrates can be easily bonded by heating at a predetermined single temperature during adhesion. However, heating during adhesion is not limited to heating at a single temperature, but, for example, step-curing including heating at 150 °C for 100 sec and then at 200 °C for 100 sec or post-curing including thermocompression bonding at 180 °C for 10 sec before curing for 10 min in an oven at 200 °C may be conducted. Furthermore, metal bonding of solder particles constituting the solder powder 103 forms connection of the electrode with the solder in the adhesive tape 101, resulting in a lower connection resistance and higher connection reliability.

An adhesive tape of the present invention exhibits excellent adhesiveness to a bonded material and higher reliability in electric connection between conductive members. For example, an adhesive tape of this invention may be used as an adhesive tape in a connected structure having a pair of conductive members where an adhesive tape is disposed between the pair of conductive members for electric connection between the pair of conductive members.
An adhesive tape of the present invention may be used in electronics for bonding electronic or electric components and electrically connecting the components. Specific examples of such electronics include computers, televisions, cellular phones, game devices, various communication devices and measuring devices.
Since an adhesive tape of the present invention can provide reliable bonding even when a bonding area of a conductive member in a bonded material is small, the tape can be suitably used for connecting a substrate or chip in, for example, a semiconductor package.

For example, an adhesive tape of the present invention may be used for adhesion between substrates in a semiconductor package.
In a semiconductor package using an adhesive tape of the present invention, for example, a first substrate, an adhesive tape and a second substrate are sequentially stacked, and a first electrode in the first substrate and a second electrode in the second substrate are connected via a solder region in the adhesive tape.

After adhesion, an adhesive tape has a resin and a solder region penetrating the resin. A curing agent having flux activity may or may not remain within the resin.

The solder region gradually expands from the inside of the adhesive tape toward the first and the second electrodes as described later in Examples. The solder region has a shape expanding in both electrode sides, resulting in excellent adhesiveness of the solder region to the resin in the adhesive tape and a large contact area between the first or the second electrode and the solder region.

When an adhesive tape of the present invention is used for adhesion of a substrate, there may or may not be a solder resist on the surfaces of the first and the second substrates.

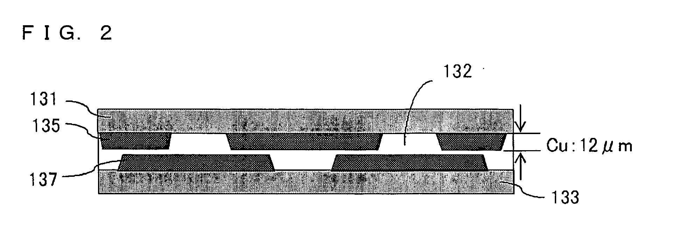

FIG. 2 is a cross-sectional view illustrating a method for forming connection between substrates without a solder resist.
In FIG. 2, there are formed a first electrode 137 and a second electrode 135 on a first base material 133 and a second base material 131, respectively. An adhesive tape of the present invention may be disposed between the substrates and heated at a predetermined temperature, to bond the substrates via a resin 132 and to move the solder powder to the surfaces of the first electrode 137 and the second electrode 135 in a self-aligningmanner, resulting in forming connection between these electrodes via a solder region.

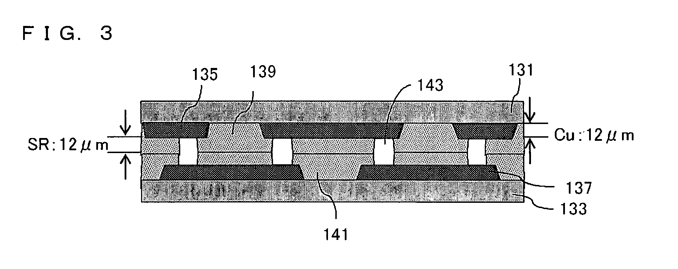

FIG. 3 is a cross-sectional view illustrating a method for forming connection between substrates with a solder resist. A basic configuration in FIG. 3 is as illustrated in FIG. 2, except that a first solder resist layer 141 and a second solder resist layer 139 are disposed on a first base material 133 and a second base material 131, respectively and a first electrode 137 and a second electrode 135 are buried in the first solder resist layer 141 and the second solder resist layer 139, respectively. In addition, at a given position in a region through which a first electrode 137 and a second electrode 135 face each other, a void 143 is formed penetrating the first solder resist layer 141 and the second solder resist layer 139.

Again, when forming adhesion between these base materials, an adhesive tape of the present invention (not shown) is disposed between the substrates and heated at a predetermined temperature. Then, a solder powder moves to the surfaces of the first electrode 137 and the second electrode 135 exposed from the void 143, to fill the void 143. Thus, a solder region forms connection between the interconnects.

An adhesive tape of the present inventionmaybe used for adhesion between semiconductor chips in a semiconductor package.

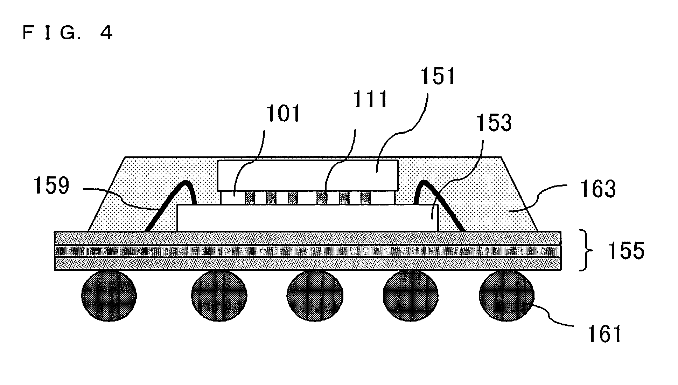

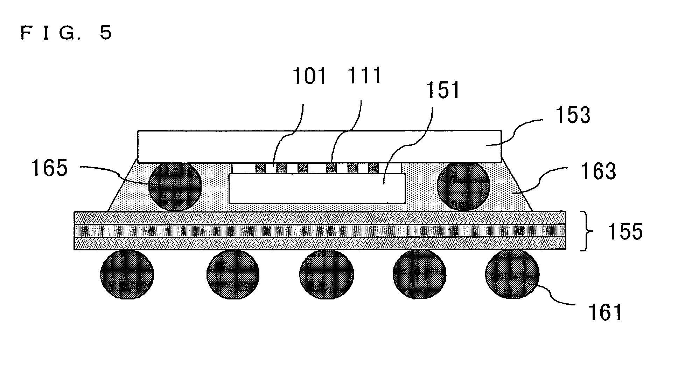

FIG. 4 and FIG. 5 are cross-sectional views illustrating a configuration of a semiconductor package where semiconductor chips are adhered via an adhesive tape.

In FIG. 4, a second semiconductor chip 153, an adhesive tape 101 and a first semiconductor chip 151 are sequentially stacked, and an electrode (not shown) in the second semiconductor chip 153 and an electrode (not shown) in the first semiconductor chip 151 are connected via a solder region 111 in the adhesive tape 101. An electrode formed in the rear surface of the second semiconductor chip 153 and an electrode in a chip-mounting substrate (mounting substrate 155) are connected by a wire 159. The first semiconductor chip 151, the second semiconductor chip 153 and the wire 159 are encapsulated with an encapsulating resin 163. There are a plurality of bump electrodes 161 in the rear surface of the mounting substrate 155.

A basic configuration in FIG. 5 is as illustrated in FIG. 4, except that in FIG. 5, the second semiconductor chip 153 is flip-bonded to a mounting substrate 155 through a bump electrode 165 and the first semiconductor chip 151 is disposed between the mounting substrate 155 and the second semiconductor chip 153.

In FIG. 4 and FIG. 5, the first semiconductor chip 151 and the second semiconductor chip 153 are adhered via the adhesive tape of the invention 101. Thus, a package maybe thinner than a configuration where chips are connected via a bump electrode. Furthermore, using the adhesive tape 101 allows chips to be bonded in a simple process and allows electrodes in the chips to be stably connected with improved connection reliability.

In addition, an adhesive tape of the present invention may be used for adhesion between substrates when a mounting substrate in a semiconductor package is further mounted on another substrate. For example, the tape can be used in secondary mounting of a semiconductor package on, for example, a PC board.

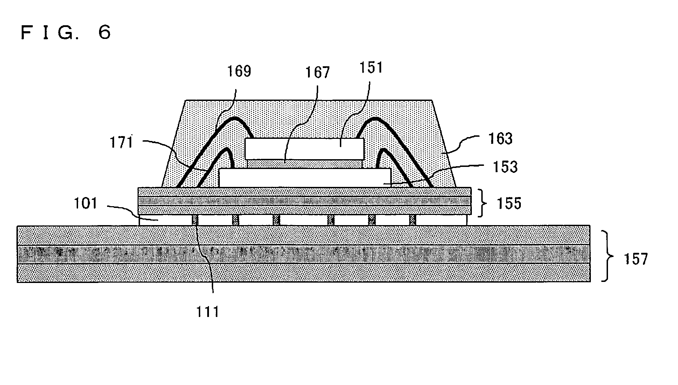

FIG. 6 is a cross-sectional view illustrating a configuration of such a semiconductor package. In FIG. 6, via an adhesive tape 101 are bonded a first substrate (mounting substrate 155) on which semiconductor chips (a first semiconductor chip 151 and a second semiconductor chip 153) are mounted and a second substrate (substrate 157) on which the mounting substrate 155 is mounted. The substrate 157 may be, for example, a PC board. The space between the first semiconductor chip 151 and the second semiconductor chip 153 is filled with a resin 167. Electrodes (not shown) mounted on the first semiconductor chip 151 and the second semiconductor chip 153 are connected to electrodes (not shown) on the mounting substrate 155 via a wire 169 and a wire 171, respectively.

Since the mounting substrate 155 and the substrate 157 are bonded via the adhesive tape 101 in FIG. 6, there can be formed stable connection between the electrodes on the substrates with higher reliability. By using the adhesive tape 101, a distance between the substrates can be reduced, so that the overall package can be thinner.

Although some embodiments of the present invention have been described with reference to the drawing, such description is for illustrative purposes only and various configurations other than the above-mentioned may be employed.

### EXAMPLES

### (Preparation of an adhesive tape)

Adhesive tapes with a thickness of 40 µm containing a resin, a solder powder and a curing agent having flux activity (Examples 1 to 21) were prepared. Additionally, an adhesive tape containing a resin and a solder powder but not containing a curing agent having flux activity (Comparative Example 1) was prepared.

Table 1 to Table 5 show blending rates of individual components in parts by weight. For each of Examples and Comparative Example, the components shown in Table 1 to Table 5 were dissolved in an aromatic hydrocarbon solvent such as toluene and xylene, an ester organic solvent such as ethyl acetate and butyl acetate or a ketone organic solvent such as acetone and methyl ethyl ketone, to prepare a varnish, which was then applied to a polyester sheet and dried at a sufficient temperature to evaporate the organic solvent.

In Examples 1 to 21, adhesive tapes exhibiting excellent depositability were prepared.

### (Evaluation of connection between substrates)

Each of the adhesive tapes in Examples 1 to 21 and Comparative Example 1 was used to form connection between substrates without a solder resist shown in FIG. 2. The substrate usedwas FR-4 with a plate thickness of 0.4 mm, a Ni/Au plated copper foil thickness of 12 µm, a circuit width/an inter-circuit width of 300 µm/100 µm and an overlapping width of the upper and the lower circuits of 100 µm. An adhesive tape was disposed between the substrates and further a silicon rubber with a thickness of 200 µm was disposed on the upper surface of the substrate such that an uniform pressure was applied, and then subjected to thermal compression bonding at 220 °C and 2 MPa for 600 sec for forming connection.

Furthermore, each of the adhesive tapes in Examples 1 to 21 and Comparative Example 1 was used to form connection between substrates using a solder resist shown in FIG. 3. The substrate used was FR-4 with a plate thickness of 0.4 mm, a Ni/Au-plated copper foil thickness of 12 µm, a solder resist thickness (a thickness from the upper surface of the circuit) 12 µm, a circuit width/an inter-circuit width of 300 µm/100 µm and an overlapping width of the upper and the lower circuits of 100 µm. An adhesive tape was disposed between the substrates and further a silicon rubber with a thickness of 200 µm was disposed on the upper surface of the substrate such that an uniform pressure was applied, and then subjected to thermal compression bonding at 180 °C and 2 MPa for 600 sec for forming connection.

For the stacks thus prepared, a connection resistance between adjacent terminals was measured at 12 points by a four terminal method and an average was used as a measured value. In Table 1 to Table 5, the results are evaluated as "○" when a measured value is 30 mΩ or less and "x" when a measured value is 30 mΩ or more.

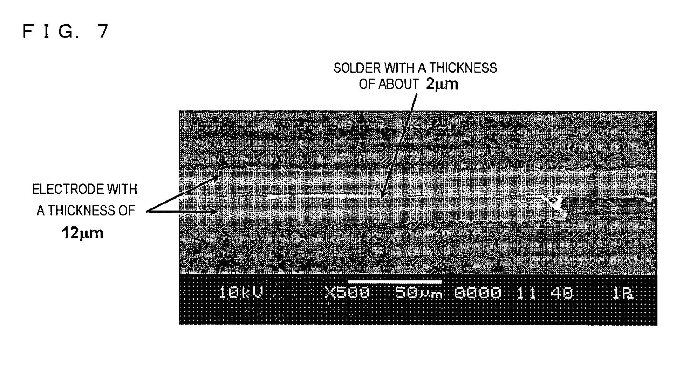

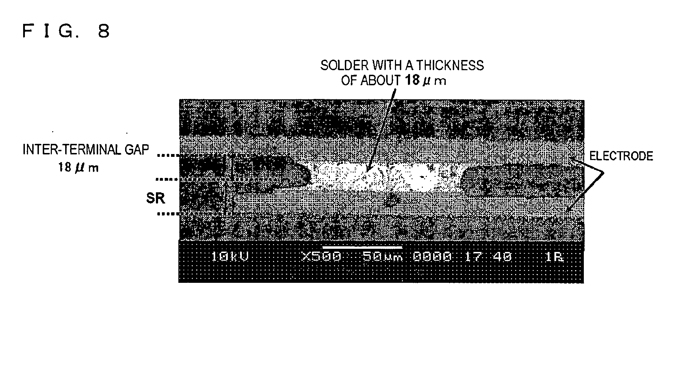

For each of Examples and Comparative Example, cross sections of 10 terminals were observed and evaluated as "○" when solder conductive cylinders were formed in all terminals as shown in FIGs. 7 and 8, or as "x" when one or more terminals did not have a conductive cylinder.

FIG. 7 is a cross-sectional view illustrating the results for a stack without a solder resist in Example 1 by scanning electron microscopy (SEM). As shown in FIG. 7, a solder thickness was 2 µm and good solder conductivity was indicated.

FIG. 8 is a cross-sectional view illustrating the results for a stack having a solder resist in Example 1 by SEM. As shown in FIG. 8, an inter-terminal gap was about 18 µm. A solder thickness was 18 µm and good solder conductivity was indicated. A solder region connecting electrodes had a shape expanding in both electrode sides.

[Table 1]

**Table 1**

| Composition | Punction | Component | Structure etc. | Example 1 | Example 2 | Example 3 | Example 4 | Example 5 |
|---|---|---|---|---|---|---|---|---|
| | Depositability impartment Elastic modulus lowering | Acrylic rubber | (Butyl acrylate)-(Ethyl acrylate)-(Acrylonitrile) = 30 mol%/30 mol%/40 mol% Molecular weight = 850,000 | 25.9 | 25.9 | 25.9 | 25.9 | 25.9 |
| | | Polyvinylbutyral resin | Polymerization degree = 1700, Acetylation degree = 3 mol% or less, Butyralation degree = 65 mol% or more, Flow softening point = 225 °C | | | | | |
| | | Phenoxy resin | Bisphenol A backbone, Number average molecular weight = 30,000 | | | | | |
| | Curing component 1 | Epoxy resin | A structural name is described in *1 | 24.5 | 24.5 | 24.5 | 24.5 | 24.5 |
| | Curing component 2 | Epoxy resin | Cresol novolac type epoxy resin, Softening point 80 °C | 16.3 | 19.3 | 6.3 | 16.3 | 16.3 |
| | Curing component 3 | Epoxy resin | Liquid bis-F type epoxy, Epoxy equivalent = 170 | 7.5 | 7.5 | 7.5 | 7.5 | 7.5 |
| | Curing agent | Phenol novolac | Softening point = 20.2 100 °C, OH equivalent = 104 3- Glycidoxypropyltrimethoxysilane | 0.1 | 20.2 | 20.2 | 20.2 | 20.2 |
| | Adhesiveness impartment 1 | Silane coupling agent | | | 0.1 | 0.1 | 0.1 | 0.1 |
| | Adhesiveness impartment 2 | Silene coupling agent | M-phenyl-3-aminopropyltrimethoxysilane | 0.35 | 0.35 | 0.35 | 0.35 | 0.35 |
| | Curing catalyst | Imidazole | 2-Pbenpl-4,5- dihydtoxyimidozole | 0.15 | 0.15 | 0.15 | 0.15 | 0.15 |
| | | Imidazole | 2-Phenyl-4-methylimidazole | | | | | |
| | Curing agent having flux activity | Sebacic acid | HOOC-(CH₂)₆-COOH | 5.0 | 2.0 | 15.0 | | |
| | | Adipic cid | HOOC-(CH₂)₄-COOH | | | | | 5.0 |
| | | | HOOC-(CH₂)₁₀-COOH | | | | | |
| | | Gentisic acid | 2,5-Dihydroxybenzoic acid | | | | 5.0 | |
| | Resin total | | | 100.0 | 100.0 | 100.0 | 100.0 | 100.0 |
| | Conductive particle | Solder powder | Sn/Bi = 42/58, 60 Melting point = 138 °C, Average particle size = 35 µm | | 60 | 60 | 60 | 60 |
| | | | Sn/Bi = 42/58, Melting point = 138 °C, Average particle size = 20 µm | | | | | |
| | | | Sn/Bi = 42/58, Melting point = 138 °C, Average particle size = 12 µm | | | | | |
| | | | Sn/In = 48/52, Melting point = 118 °C, Average particle size = 35 µm | | | | | |
| Evaluation results | Adjacent terminal connection resistance | Substrate without a solder resist | Measured value (mΩ) | 14 | 20 | 14 | 22 | 16 |
| | | | Evaluation | ○ | ○ | ○ | ○ | ○ |
| | | Substrate having a solder resist | Measured value (mΩ) | 15 | 19 | 16 | 25 | 15 |
| | | | Evaluation | ○ | ○ | ○ | ○ | ○ |
| | Conductive cylinder formation between an upper and a lower circuits | Substrate without a solder resist | Evaluation | ○ | ○ | ○ | ○ | ○ |
| | | Substrate having a solder resist | Evaluation | ○ | ○ | ○ | ○ | ○ |

| | | | | | | | | |
|---|---|---|---|---|---|---|---|---|
| *1: a mixture of 2-[4-(2,3-epoxypropoxy)phenyl]-2-[4-[1,1-bis[4-(2,3-epoxypropoxy)phenyl]ethyl] phenyl]propane and 1,3-bis[4-[1-[4-(2,3-epoxypropoxy)phenyl]-1-[4-[1-[4-(2,3-epoxypropoxy)phenpl]-1-methyl]ethyl]phenyl]phenoxy]-2-propenol | | | | | | | | |

[Table 2]

**Table 2**

| Composition | Function | Component | Structure etc. | Example 6 | Example 7 | Example 8 | Example 9 | Example 10 |
|---|---|---|---|---|---|---|---|---|
| | Depositability impartment Elastic modulus lowering | Acrylic rubber | (Butyl acrylate)-(Ethyl acrylate)-(Acrylonitrile) = 30 mol%/30 mol%/40 mol% Molecular weight = 850,000 | 25.9 | 25.9 | 25.9 | 25.9 | 25.9 |
| | | Polyvinylbutyral resin | Polymerization degree = 1700, Acetylation degree = 3 mol% or less, Butyralation degree = 65 mol% or more, Flow softening point = 225 °C | | | | | |
| | | Phenoxy resin | Bisphenol A backbone, Number average molecular weight = 30,000 | | | | | |
| | Curing component 1 | Epoxy resin | A structural name is described in *1 | 24.5 | 24.5 | 24.5 | 24.5 | 24.5 |
| | Curing component 2 | Epoxy resin | Cresol novolac type epoxy resin, Softening point 80 °C | 16.3 | 16.3 | 16.3 | 16.3 | 16.3 |
| | Curing component 3 | Epoxy resin | Liquid bis-F type epoxy, Epoxy equivalent = 170 | 7.5 | 7.5 | 7.5 | 7.5 | 7.5 |
| | Curing agent | Phenol novolac | softening point = 100 °C, OH equivalent = 104 | 20.2 | 20.2 | 20.2 | 20.2 | 20.2 |
| | Adhesivene Silane ss coupling impartment agent 1 | | 3-Glycidoxypropyltrimethoxysilane | 0.1 | 0.1 | 0.1 | 0.1 | 0.1 |
| | Adhesiveness Silane coupling impartment agent 2 | | N-phenyl-3-aminopropyltrimethoxysilane | 0.35 | 0.35 | 0.35 | 0.35 | 0.35 |
| | Curing catalyst | Imidazole | 2-Phenyl-4,5-dihydroxyimidezole | 0.15 | | 0.15 | 0.15 | 0.15 |
| | | Imidazole | 2-Phenyl-4-methylimidazole | | 0.15 | | | |
| | Curing agent having activity | Sebacic acid | HOOC-(CH₂)₆-COOH | | 5.0 | 5.0 | 5.0 | 5.0 |
| | | Adipic acid | HOOC-(CH₂)₄-COOH | | | | | |
| | | | HOOC-(CH₂)₁₀-COOH | 5.0 | | | | |
| | | Gentisic acid | 2,5-Dihydroxybenzoic acid | | | | | |
| | Resin total | | | 100.0 | 100.0 | 100.0 | 100.0 | 100.0 |
| | Conductive particle | Solder powder | Sn/Bi = 42/58, Melting point = 138 °C, Average particle size = 35 µm | 60 | 60 | | | |
| | | | Sn/Bi = 42/58, Melting point = 138 °C, Average particle size = 20 µm | | | 60 | | |
| | | | Sn/Bi = 42/58, Melting point = 138 °C, Average particle size = 12 µm | | | | 60 | |
| | | | Sn/In = 48/52, Melting point = 118 °C, Average particle size = 35 µm | | | | | 60 |
| Evaluation results | Adjacent Substrate terminal connection without resistance a solder resist | | Measured value (mΩ) | 15 | 24 | 22 | 27 | 18 |
| | | | Evaluation | ○ | ○ | ○ | ○ | ○ |
| | Substrate Measured value (mΩ) | | | 17 | 22 | 23 | 26 | 17 |
| | having Evaluation a solder resist | | | ○ | ○ | ○ | ○ | ○ |
| | Conductive Substrate Evaluation cylinder formation without between an a solder upper and resist | | | ○ | ○ | ○ | ○ | ○ |
| | a lower circuits Substrate Evaluation having a solder resist | | | ○ | ○ | ○ | ○ | ○ |

| | | | | | | | | |
|---|---|---|---|---|---|---|---|---|
| *1: a mixture of 2-[4-(2,3-epoxypropoxy)pheny]-2-[4-[1,1-bis[4-(2,3-epoxypropoxy)pheny]ethyl] phenyl]propane and 1,3-bis[4-[1-[4-(2,3-epoxypropoxy)phenyl]-1-[4-[1-[4-(2,3-epoxypropoxy)phenyl]-1-methyl]ethyl]phenyl]phenoxy]-2-propanol | | | | | | | | |

[Table 3]

**Table 3**

| Composition | Function | Component | Structure etc. | Example 11 | Example 12 | Example 13 | Example 14 | Comparative Example 1 |
|---|---|---|---|---|---|---|---|---|
| | Depositability impartment Elastic modulus lowering | Acrylic bubber | (Butyl acrylate)-(Ethyl acrylate)-(Acrylonitrile) - 30 mol%/30 mol%/40 mol% Molecular weight - 850,000 | | | 15.0 | 45.0 | 25.9 |
| | | Polyvinylbutyral resin | Polymerization degree - 1700, Acetylation degree - 3 mol% or less, Butyrelation degree - 65 mol% or more, Flow softening point - 225 °C | 25.9 | | | | |
| | | Phenoxy resin | Bisphenol A backbone, Number average molecular weight - 30,000 | | 25.9 | | | |
| | Curing component 1 | Epoxy resin | A structural name is described in *1 | 24.5 | 24.5 | 30.0 | 12.0 | 24.5 |
| | Curing component 2 | Epoxy resin | Cresol novolac type epoxy resin, Softening point 60 °C | 16.3 | 16.3 | 16.3 | 16.3 | 16.3 |
| | Curing component 3 | Epoxy resin | Liquid bis-F type epoxy, Epoxy equivalent - 170 | 7.5 | 7.5 | 7.5 | 7.5 | 7.5 |
| | Curing agent | Phenol novolac | Softening point - 100 °C, OH equivalent - 104 | 20.2 | 20.2 | 25.6 | 13.6 | 25.2 |
| | Adhesiveness impartment 1 | Silane coupling agent | 3-Glycidoxypropyl trimethoxysilane | 0.1 | 0.1 | 0.1 | 0.1 | 0.1 |
| | Adhesiveness impartment 2 Curing catalyst | Silane coupling agent | N-phenyl-3-aminopropyltrimethoxysilane | 0.35 | 0.35 | 0.35 | 0.35 | 0.35 |
| | | Imidazole | 2-Phenyl-4,5-dihydroxyimidatole | 0.15 | 0.15 | 0.15 | 0.15 | 0.15 |
| | | Imidazole | 2-Phenyl-4-methylimidazole | | | | | |
| | Curing agent flux activity | Sebacic acid | HOOC-(CH₂)₄-COOH | 5.0 | 5.0 | 5.0 | 5.0 | |
| | | Adipic acid | HOOC-(CH₂)₄-COOH | | | | | |
| | | | HOOC-(CH₂)₁₀-COOH | | | | | |
| | | Gentisic acid | 2,5-Dihydroxybenzole acid | | | | | |
| | Resin total | | | 100.0 | 100.0 | 100.0 | 100.0 | 100.0 |
| | Conductive particle | Solder powder | Sn/Bi - 42/58, Melting point - 138 °C, Average particle size - 35 µm | 60 | 60 | 60 | 60 | 60.0 |
| | | | Sn/Bi - 42/58, Melting point - 138 °C, Average particle size - 20 µm | | | | | |
| | | | Sn/Bi - 42/58, Melting point - 138 °C, Average particle size - 12 µm | | | | | |
| | | | Sn/In - 48/52, Melting point - 110 °C, Average particle size - 35 µm | | | | | |
| Evaluation results | Adjacent terminal connection resistance | Substrate without a solder resist | Measured value (mΩ) | 25 | 24 | 15 | 24 | open |
| | | | Evaluation | ○ | ○ | ○ | ○ | × |
| | | Substrate having a solder resist | Measured value (mΩ) | 24 | 22 | 14 | 23 | open |
| | | | Evaluation | ○ | ○ | ○ | ○ | × |
| | Conductive cylinder formation between an upper and a lower circuits | Substrate without a solder resist | Evaluation | ○ | ○ | ○ | ○ | × |
| | | Substrate having a solder resist | Evaluation | ○ | ○ | ○ | ○ | × |

| | | | | | | | | |
|---|---|---|---|---|---|---|---|---|
| *1: a mixture of 2-[4-(2,3-epoxypropoxy)phenyl]-2-[4-(1,1-bis[4-(2,3-epoxypropoxy)phenyl]ethyl] phenyl]propane and 1,3-bis[4-[1-[4-(2,3-epoxypropoxy)phenyl]-1-[4-[1-[4-(2,3-epoxypropoxy)phenyl]-1-methyl]ethyl]phenyl]phenoxy]-2-propanol | | | | | | | | |

[Table 4]

**Table 4**

| Composition | Punction | | Component | | Structure etc. | Example 15 | Example 16 | Example 17 | Example 18 |
|---|---|---|---|---|---|---|---|---|---|
| | Depositability impartment Elastic modulus lowering | | Acrylic rubber | | (Butyl acrylate)-(Ethyl acrylate)-(Acrylonitrile) = 30 mol%/30 mol%/40 mol% Molecular weight = 850,000 | | | | |
| | | | Polyvinylbutyral resin | | Polymerization degree = 1700, Acetylation degree = 3 mol% or less, Butyralation degree = 65 mol% or more, Flow softening point = 225 °C | | | | |
| | | | Phenoxy resin | | Bisphenol A backbone, Number average molecular weight = 30,000 | | | | |
| | | | | | Bisphenol P backbone, weight average molecular weight = 50,000 | 14.2 | 10.1 | 14.2 | 10.1 |
| | | | | | Fluorene backbone, weight average molecular weight = 50,000 | 14.2 | 10.1 | 14.2 | 10.1 |
| | curing component 1 | | Epoxy resin | | A structural name is described in *1 | | 30.0 | | 30.0 |
| | Curing component 2 | | Epoxy resin | | Cresol novolac type epoxy resin, Softening point 80 °C | | 20.1 | | 20.1 |
| | Curing component 4 | | Epoxy resin | | Liquid bis-A type epoxy, Epoxy equivalent = 180 | 45.7 | | 45.7 | |
| | Curing agent | | Phenol novolac | | Softening point = 100 °C, OH equivalent = 104 | 20.4 | 24.3 | 20.4 | 24.3 |
| | Adhesiveness impartment 1 | | Silene coupling agent | | 3-Glycidoxypropyltrimethoxysilene | | 0.3 | | 0.3 |
| | Adhesiveness impartment 2 | | Silene coupling agent | | N-phenyl-3-aminopropyltrimethoxysilane | 0.50 | | 0.50 | |
| | Curing catalyst | | Imidazole | | 2-Phenyl-4,5-dihydroxyimidazole | | 0.1 | | 0.1 |
| | | | Imidazole | | 2-Phenyl-4-methylimidozole | 0.01 | | 0.01 | |
| | Curing agent having flux activity | | Sebacic acid | | HOOC-(CH₂)ₛ-COOH | 5.0 | 5.0 | | |
| | | | Adipic acid | | HOOC-(CH₂)₄-COOH | | | | |
| | | | | | HOOC-(CH₂)₁₀-COOH | | | | |
| | | | Gentisic acid | | 2,5-Dihydroxybenzoic acid | | | | |
| | | | Phenolphthalin | | | | | 5.0 | 5.0 |
| | Resin total | | | | | 100.01 | 100.0 | 100.01 | 100.0 |
| | Conductive particle | Solder powder | | Sn/Bi = 42/58, Melting point = 138 °C, Average particle size = 35 µm | | 90 | 90 | 90 | 90 |
| | | | | Sn/Bi = 42/58, Melting point = 138 °C, Average particle size = 20 µm | | | | | |
| | | | | Sn/Bi = 42/58, Melting point = 138 °C, Average particle size = 12 µm | | | | | |
| | | | | Sn/In = 48/52, Melting point = 118 °C, Average particle size = 35 µm | | | | | |
| **E**valuation results | Adjacent terminal connection resistance | Substrate without a solder resist | | Measured value (mΩ) | | 22 | 20 | 26 | 25 |
| | | | | Evaluation | | ○ | ○ | ○ | ○ |
| | | Substrate having a solder resist | | Measured value (mΩ) | | 21 | 20 | 27 | 27 |
| | | | | Evaluation | | ○ | ○ | ○ | ○ |
| | Conductive cylinder formation between an upper and a lower and circuits | Substrate without a solder resist | | Evaluation | | ○ | ○ | ○ | ○ |
| | | Substrate having a solder resist | | Evaluation | | ○ | ○ | ○ | ○ |

| | | | | | | | | | |
|---|---|---|---|---|---|---|---|---|---|
| *1: a mixture of 2-[4-(2,3-epoxypropoxy)phenyl]-2-[4-[1,1-bis[4-(2,3-epoxypropoxy)phenyl]ethyl] phenyl]propane and 1,3-bis[4-[1-(4-(2,3-epoxypropoxy)phenyl]-1-[4-[1-[4-(2,3-epoxypropoxy)phenyl]-1-methyl]ethyl]phenyl]phenoxy]-2-propenol | | | | | | | | | |

[Table 5]

**Table 5**

| Composition | Function | | component structure etc. | | Examle 19 | Example 20 | Example 21 |
|---|---|---|---|---|---|---|---|
| | Depositability impartment Elastic modulus lowering | | Acrylic rubber | (Butyl acrylate)-(Ethyl acrylate)-(Acrylonitrile) = 30 mol%/30 mol%/40 mol% Molecular weight = 850,000 | | | |
| | | | Polyvinylbutyral resin | Polymerization degree = 1700, Acetylation degree = 3 mol% or less, Butyralation degree = 65 mol% or more, Flow softening point = 225 °C | | | |
| | | | Phenoxy resin | Bisphenol A backbone, Number average molecular weight = 30,000 | | | |
| | | | | Bisphenol P backbone, weight average molecular weight = 50,000 | 28.4 | 28.4 | 15.0 |
| | | | | Fluorene backbone, weight average molecular weight = 50,000 | | | |
| | Curing component 1 | | Epoxy resin | A structural name is described in *1 | | | |
| | Curing component 2 | | Epoxy resin | Cresol novolac type epoxy resin, Softening point 80 °C | | | |
| | Curing component 4 | | Epoxy resin | Liquid bis-A type epoxy, Epoxy equivalent = 180 | 45.7 | 45.7 | 54.1 |
| | Curing agent | | Phenol novolac | Softening point = 100 °C, OH equivalent = 104 | 20.4 | 20.4 | 25.4 |
| | Adhesiveness impartment 1 | | silane coupling agent | 3-Glycidoxypropyltrimethoxysilane | | | |
| | Adhesiveness impartment 2 | | Silane coupling agent | N-phenyl-3-aminopropyltrimethoxyslilane | 0.50 | 0.50 | 0.50 |
| | Curing catalyst | | Imidazole | 2-Phenyl-4,5- dihydroxyimidazole | | | |
| | | | Imidazole | 2-Phenyl-4-methylimidazole | 0.01 | 0.01 | 0.01 |
| | Curing agent having flux activity | | Sebacic acid | HOCC-(CH₂)₈-COOH | 5.0 | 5.0 | 5.0 |
| | | | Adipic acid | HOOC-(CH₂)₄-COOH | | | |
| | | | | HOOC-(CH₂)₁₀-COOH | | | |
| | | | Gentisic acid | 2,5-Dihydroxybenzoic acid | | | |
| | | | Phenolphthalin | | | | |
| | Resin total | | | | 100.01 | 100.01 | 100.01 |
| | Conductive particle | Solder powder | | Sn/Bi = 42/58, Melting point = 138 °C, Average particle size = 35 µm | 90 | 40 | 40 |
| | | | | Sn/Bi = 42/58, Melting point = 138 °C, Average particle size = 20 µm | | | |
| | | | | Sn/Bi = 42/58. Melting point = 138 °C, Average particle size = 12 µm | | | |
| | | | | Sn/In = 48/52, Melting point = 118 °C, Average particle size = 35 µm | | | |
| Evaluation results | Adjacent terminal connection resistance | Substrate without a solder resist | | Measured value (mΩ) | 18 | 23 | 21 |
| | | | | Evaluation | ○ | ○ | ○ |
| | | Substrate | | Measured value (mΩ) | 18 | 22 | 20 |
| | | having a solder resist | | Evaluation | ○ | ○ | ○ |
| | Conductive cylinder formation between an upper and a lower circuits | Substrate without a solder resist | | Evaluation | ○ | ○ | ○ |
| | | Substrate having a solder resist | | Evaluation | ○ | ○ | ○ |

| | | | | | | | |
|---|---|---|---|---|---|---|---|
| *1: a mixture of 2-[4-(2,3-epoxypropoxy)phenyl]-2-[4-[1,1-bis[4-(2,3-epoxyprapoxy)phenyl)ethyl) phenyl]propane and 1,3-bis[4-[1-[4-(2,3-opoxypropoxy)phenyl]-1-[4-[1-(1-(2,3-apoxypropoxy)phenyl)-1-methyl]ethyl]phenyl]phenoxy]-2-propanol | | | | | | | |

### (Evaluation of wettability to a copper interconnect surface)

In this example, adhesive tapes as described in Example 1 were prepared, varying the types of the solder powder and the curing agent having flux activity in Table 1. Then, material combinations of the curing agent having flux activity and a solder powder were evaluated for their wettability to a copper interconnect surface.

The solidpowders usedwere Sn/Pb, Sn/Bi, Sn/Zn/Bi and Sn/Ag/Cu. In each solder powder, a curing agent having flux activity acting as a curing catalyst for an epoxy resin was gentisic acid or sebacic acid. The results indicated good wettability in any combination. A combination of Sn/Bi and sebacic acid exhibited the most preferable wettability.

### (Investigation of a solder powder particle size)

In this example, varying a particle size of a solder powder in an adhesive tape, effects of the particle size on wettability to a copper interconnect surface were evaluated. In the adhesive tape described in Example 1, an average particle size of a solder powder was 12 µm, 20 µm and 35 µm. A content of the solder powder was 20 % by weight to the amount 100 % by weight of the components except the solder powder. The adhesive tape was disposed between substrates without a solder resist layer and then subjected to thermal compression bonding at 220 °C and 2 MPa for 600 sec. The results indicated substantial wettability to a copper interconnect in any particle size. In terms of a particle size, wettability was higher in the order of 35 µm, 20 µm and 12 µm.

## Claims

1. An adhesive tape electrically connecting conductive members, comprising
a resin,
a solder powder and
a curing agent having flux activity,
wherein said solder powder and said curing agent having flux activity are contained in said resin.

2. The adhesion tape as claimed in Claim 1, wherein by heating, said solder powder contained in said resin moves to the surface of said conductive member in a self-aligning manner.

3. The adhesion tape as claimed in Claim 2, wherein said resin comprises an epoxy resin and an acrylic rubber.

4. The adhesion tape as claimed in Claim 2, wherein said resin comprises an epoxy resin and a phenoxy resin.

5. The adhesion tape as claimed in Claim 2, wherein said curing agent having flux activity is a carboxyl group-containing compound.

6. The adhesion tape as claimed in Claim 5, wherein said curing agent having flux activity is a compound having a carboxyl group and a group reactive to an epoxy group.

7. The adhesion tape as claimed in Claim 6, wherein said curing agent having flux activity is a benzoic acid derivative.

8. The adhesion tape as claimed in Claim 5, wherein said curing agent having flux activity is a compound represented by the following formula (1):
HOOC- (CH₂)ₙ-COOH (1)
(in the above formula (1), n is an integer of 4 to 10 both inclusive).

9. The adhesion tape as claimed in Claim 5, wherein said curing agent having flux activity comprises at least one of sebacic acid and gentisic acid.

10. The adhesion tape as claimed in Claim 2, further comprising an imidazole compound as a curing catalyst.

11. The adhesion tape as claimed in Claim 10, wherein said imidazole compound has a melting point of 150 °C or higher.

12. The adhesion tape as claimed in Claim 11, wherein said curing catalyst comprises 2-phenylhydroxyimidazole or 2-phenyl-4-methylhydroxyimidazole.

13. The adhesion tape as claimed in Claim 10, wherein said curing catalyst comprises 2-phenyl-4,5-dihydroxyimidazole or 2-phenyl-4-methylimidazole.

14. The adhesion tape as claimed in Claim 2, wherein said solder powder is an alloy comprising at least two selected from the group consisting of Sn, Ag, Bi, In, Zn and Cu.

15. The adhesion tape as claimed in Claim 14, wherein said solder powder has a melting point of 100 to 250 °C both inclusive.

16. The adhesion tape as claimed in Claim 2, wherein said resin comprises an epoxy resin which is solid at an ambient temperature and an epoxy resin which is liquid at an ambient temperature.

17. The adhesion tape as claimed in Claim 16, wherein
said epoxy resin which is solid at an ambient temperature comprises a solid trifunctional epoxy resin and a cresol novolac type epoxy resin, and
said epoxy resin which is liquid at an ambient temperature is a bisphenol A type epoxy resin or bisphenol F type epoxy resin.

18. The adhesion tape as claimed in Claim 2, further comprising a silane coupling agent.

19. The adhesion tape as claimed in Claim 18, wherein said silane coupling agent comprises at least one of an epoxy silane coupling agent and an aromatic-containing aminosilane coupling agent.

20. A semiconductor package comprising
a chip-mounting substrate, and
a first and a second semiconductor chips deposited on one surface of said chip-mounting substrate,
wherein said first and said second semiconductor chips are bonded via the adhesive tape as claimed in Claim 1.

21. A semiconductor package comprising
a first substrate mounting a semiconductor chip and
a second substrate mounting said first substrate,
wherein said first and said second substrates are bonded via the adhesive tape as claimed in Claim 1.

22. Electronics wherein the adhesive tape as claimed in Claim 1 is used for electrically connecting electronic or electric components.
